# EUROPEAN PATENT SPECIFICATION

(11) **EP 0 463 025 B1**
(45) Date of publication and mention of the grant of the patent: **14.06.1995**
(21) Application number: 90904401.8
(22) Date of filing: 09.03.1990
(51) Int. Cl.: C06B 45/14, C06C 5/00, C23C 14/20

(54) **PYROTECHNIC MATERIALS**
PYROTECHNISCHE MATERIALIEN
MATIERES PYROTECHNIQUES

(30) Priority: 13.03.1989 GB 8905747
(43) Date of publication of application: 02.01.1992
(73) Proprietor: Secretary of State for Defence in Her Britannic Majesty's Gov. of the United Kingdom of Great Britain and Northern Ireland, London SW1A 2HB (GB)
(72) Inventor: ALLFORD, Frederick, George, Sevenoaks Kent TN13 2HP (GB)
(74) Representative: Beckham, Robert William
(86) International application number: PCT/GB90/00359
(87) International publication number: WO 90/10611

(56) References cited:
- EP-A- 0 087 309
- EP-A- 0 193 338
- WO-A-88/08043
- DE-A- 2 648 516
- FR-A- 1 191 334
- GB-A- 2 054 108
- US-A- 3 549 436
- US-A- 3 895 129
- US-A- 3 995 559
- INSTRUMENTS AND EXPERIMENTAL TECHNIQUES. No. 6, pp. 1489-1490, November-December, 1968. NEW YORK US L.I. Nikolaichuk et.al.: "Deposition of Thin Filmsof Magnesium and Cadmium by Evaporation in Hydrogen and Helium", see pages 1489-1490
- TRANSACTIONS OF THE INSTITUTE OF METAL FINISHING. vol. 57, no. 2, February1979, LONDON GB pages 65 - 69; J.N. AVARITSIOTIS et.al.: "ION PLATING ONTOPLASTICS"

## Description

This invention relates to pyrotechnic materials, in particular but not exclusively suitable for use in pyrotechnic trains such as single and multi-train delay systems. The invention also relates to the use of such pyrotechnic materials in pyrotechnic trains.

It is well known that a wide range of pyrotechnic materials may be prepared in granular form by carefully selecting, preparing, and mixing together oxidising and oxidisable materials in specific ratios in order to achieve desired burning characteristics. Typical among such known granular combinations are oxidising polymers (such as fluoro- and chlorofluoro-hydrocarbon polymers) and oxidisable metals (such as magnesium), which in admixture are used as igniters for propellant charges and as flare compositions for emitting infrared and smoke signals. Pyrotechnic compositions of this type are disclosed in, for example, US Patent Numbers 3669020 and 3983816 and US Statutory Invention Registration H169.

Granular pyrotechnic compositions of the type consisting of polymer/metal mixtures suffer from a number of drawbacks. They are generally difficult to ignite, especially so when high energy ingredients are selected such as magnesium and polytetrafluoroethylene (PTFE). Great care must be taken in selecting ingredients of the correct particle size and shape, in mixing the ingredients in the correct ratio and in packing the composition to the correct density in a finished product since all these factors can have a considerable effect on burning characteristics. Such granular compositions can be extremely hazardous to handle, since they are liable to ignite spontaneously whilst undergoing formulation and further processing into end products. This necessitates clean room assembly conditions and the adoption of other elaborate and time-consuming safety procedures. Furthermore, they have certain limitations over other types of granular pyrotechnic composition in that they generally have fast burning rates which render them unsuitable for use in a single- or multi-train pyrotechnic delay systems for initiating an event or complex sequence of events in (for example) a missile. Conventionally, pyrotechnic delay systems are constructed from known delay cords comprising lead tubes which are first packed with a prepared pyrotechnic composition. The packed tubes are then fine drawn, cut to length, shaped and manually assembled with appropriate coupling components. The whole process is lengthy and operator dependent, has high tooling costs, and, since granular compositions are employed, requires clean room assembly and can be hazardous. The use of such lead tubes in multi-train delay systems is additionally disadvantageous in having a number of undesirable interfaces and inconsistent burning times. Furthermore, the relatively large amounts of pyrotechnic material required per unit length of tube tends to melt the lead tube and produce undesirably high gas pressures during burning of the composition, which can damage other items in the vicinity of the delay system such as plastics materials casings.

It is an object of the present invention to provide a pyrotechnic material whereby the aforementioned disadvantages of granular pyrotechnic compositions are overcome or at least mitigated in part.

It is a further object of the invention to provide a pyrotechnic train, especially a pyrotechnic delay train, whereby the aforementioned disadvantages of using granular pyrotechnic compositions in such trains is overcome or at least mitigated in part.

According to the present invention, a pyrotechnic material comprises a substrate of an oxidising polymeric material, not being a substrate film comprising an oxidising halogenated polymeric material, having vapour deposited thereon at least one layer of an oxidisable metallic material in at least one location on the surface of the substrate, the at least one layer being at least 3 »m (microns) thick and the polymeric and metallic materials being conjointly capable of reacting together exothermically on ignition.

Pyrotechnic materials including a substrate film comprising an oxidising halogenated polymeric material are the subject of copending European Patent Application 90904376.

The advantage of vapour deposition is that it maximises molecular intermingling of the polymeric and metallic materials at their interface to provide a large, intimate and essentially void-free contact area between the two. The resulting pyrotechnic material exhibits considerable resistance to spontaneous ignition. Controlled ignition of the conjoint oxidising and oxidisable materials at any selected location initiates a self-sustaining, exothermic reaction between the two materials which progresses laterally along the interface. Intimate interfacial contact is further enhanced by the nature of vapour deposition processes which are conventionally conducted in essentially oxygen-free environments such as a vacuum or a low pressure inert atmosphere, so preventing the formation of an inhibiting film of metal oxide between the metallic and polymeric materials. This in turn renders the present pyrotechnic material easier to ignite than its granular counterparts. Furthermore, vapour deposition ensures that the advantageous properties of the polymeric substrate starting material (such as flexibility, strength, and toughness) are not substantially degraded during the manufacture of the pyrotechnic product.

The substrate may be made from one or more of a variety of polymeric materials which are preferably pliant. To enable an exothermic reaction to occur between the metallic material and the substrate, the polymeric material must contain an atom chemically bound to the polymer structure that is capable of oxidising the metal, and suitable atoms include halogens (which are preferred, especially fluorine), oxygen, sulphur, nitrogen and phosphorus.

The substrate is preferably wholly or partly made of a halogenated polymer. The substrate may be made wholly of such a halogenated polymer or may alternatively be made of a mixture of a halogenated polymer and one or more other polymers and/or may alternatively have a surface layer made wholly or partly of a halogenated polymer. In order to provide a high energy polymer/metal combination in the present pyrotechnic material, the halogenated polymer is preferably a fluoropolymer or a fluorochloropolymer, especially a fluoroalkylene polymer or a fluorochloroalkylene polymer. The most preferred polymer is polytetrafluoroethylene (PTFE) which gives potentially the highest energy content pyrotechnic material. Other suitable polymers known to react exothermically with metal fuels such as Mg include, polyhexafluoropropylene, the copolymers of vinylidene fluoride and hexafluoropropylene, copolymers of tetrafluoroethylene and perfluoropropylene, copolymers of chlorotrifluoroethylene and vinylidene fluoride, homopolymers of perfluoropropylene and its copolymers with vinylidene fluoride, trifluorochloroethylene homopolymer and its copolymers with vinylidene fluoride, and mixtures of two or more such polymers with each other or with PTFE.

The thickness and composition of the metal material layer is selected to ensure reliable and consistent lateral progression characteristics of the exothermic reaction. If the layer is too thick, the reaction may self extinguish due to excessive heat conduction from the interface into the metal layer itself, whereas if then insufficient heat will be generated by the reaction to sustain lateral progression. For this reason the layer is preferably from 3 to 100 »m (microns) thick, most preferably from 3 to 50 »m (microns) thick.

The at least one metallic material layer may comprise a single metal, or two or more metals co-deposited as an alloy. The selected metal is preferably one which gives a high heat output when undergoing exothermic reaction with the oxidising polymer, especially with a halogenated polymer. For this reason, it is particularly preferred that the at least one metallic material layer comprises magnesium or a magnesium alloy for example with lithium, this being an alloy that undergoes a more exothermic reaction with the type of polymeric materials outlined above than magnesium alone, or with aluminium. The metallic material layer may comprise an alternative metal or an alloy thereof, particularly an alternative metal known to react with halogenated polymers, such as boron, beryllium, calcium, strontium, barium, sodium, lithium, aluminium, titanium or zirconium. A layer of magnesium or magnesium alloy 3-50 »m (microns) thick, especially 5-25 »m (microns) thick, is preferred, for example deposited on PTFE as described above. Vapour deposition of Mg or a Mg alloy onto a fluorinated polymer is found to be particularly advantageous because a particularly adherent metallic layer is formed, possibly due in part to a degree of chemical bonding which takes place at the interface during vapour deposition.

To moderate the exothermic reaction the metallic material may be deposited as two or more layers, with adjacent layers interlayered with a vapour-deposited layer of a moderating material (such as lead) which does not readily react exothermically with the substrate.

The pyrotechnic material of this invention may be made using general techniques of vapour deposition onto substrates which are well known in the deposition art. The preferred method of deposition for metals is physical vapour phase deposition, in which a vapour of the layer material, such as a metal eg magnesium, is caused to condense onto the surface of the substrates. If the metallic material layer is an alloy then two or more metals must be vapour deposited simultaneously onto the substrate. Deposition may be carried out in a vacuum or in a low pressure (sub-atmospheric) atmosphere of an inert gas such as argon.

For some useful applications of the present pyrotechnic material, it is desirable that the polymeric substrate be substantially consumed by the exothermic reaction in order to promote maximum heat generation for the amount of pyrotechnic material employed. In these applications, the substrate is preferably supplied in the form of a film of material especially a flexible film, in order to ensure complete combustion takes place. One particularly preferred form is a tape of flexible film, which has the advantage that it can be rolled up for example on a cylindrical former for storage and (in certain applications) subsequent use.

When the substrate is in the form of a film, the film is coated on at least one surface with the metallic material. It is however more preferred to deposit metallic layers on both sides of the film to form a metallic material-polymeric material-metallic material composite. This preferred composite arrangement has the advantage of reducing the build-up of static electrical charges on the otherwise exposed surface of the polymeric material and so reduces the possibility of accidental ignition of the pyrotechnic material. It also has the advantage of doubling the contact area between the metallic and polymeric materials, so improving the lateral progression characteristics of the exothermic reaction.

Preferably, the relative proportions of substrate film and metallic material are such that at least at the location of the film underlying the layer or layers of metallic material, the ratio of substrate to metallic material is substantially stoichiometric for the exothermic reaction but variation of the relative proportions of preferably within ±20% of the stoichiometric amounts may be used to control the combustion rate. The thickness of the film is in general determined by practical considerations. If the film is too thick, its complete combustion cannot be assured whereas manufacturing requirements will generally set the minimum thickness at which the film can be prepared. For these reasons, the film thickness is preferably between 5 and 200 »m (microns), more preferably between 10 and 100 »m (microns).

The present coated film pyrotechnic material has several applications. In one applications the material may be used as a flash transfer medium. Such a medium will in general comprise one or more longitudinal strips of the material enclosed in a containment sleeve, preferably a heat-shrunk plastics sleeve. The resilience and flexibility of the film lends to the medium the desirable characteristics of robustness, flexibility and reliability. Furthermore, if the film is made of a substantially hydrogen-free polymer the exothermic reaction between film and metallic layer or layers will be essentially gasless, so that if made strong enough the containment sleeve will contain the products of combustion without rupturing. Typically, the amount of pyrotechnic material used will be 0.05-10, preferably 0.1-5, grammes per metre of medium.

In a further application of the present coated film material the material may be spirally overwound on itself into a rolled configuration which has been found suitable for use as a propellant charge. A cylindrical roll is ideally shaped to fit within the typically cylindrical interior of a rocket motor case. The burning rates of spirally overwound coated film materials are typically many times that achievable by conventional solid propellants for rocket motors, so that they are most useful in applications where very rapid projectile accelerations are required, such as in short-range missile launch systems and/or in recoil-less guns. Furthermore, if the metallic/polymeric material combination is selected to produce an essentially gasless exothermic reaction, the products of combustion will condense rapidly and so reduce blast effects in the immediate vicinity of projectile launch. The number of film windings will affect burning rate, because as they increase the bulk of the film will become increasingly confined by overlaid material to produce a general increase in burning rate.

If the film is coated on both sides and is rolled up with a second, insulating film, then the charge can be used as an electrical capacitor with the metallic material layers acting as separate capacitor plates, and so can be electrically charged to store electrical energy required for its own ignition. A similar effect can be produced by rolling together two films of material placed one on top of the other, both films being coated on one side only and each metallic material coating facing the uncoated side of the adjacent film in contact with it. By analogy, a similar effect may be produced by stacking several coated films on top of each other, interleaved with layers of insulating film where appropriate, to provide a flat plate capacitor.

For the application of the present pyrotechnic material in a pyrotechnic train, it is preferred that the polymeric material is supported on a further substrate or present in considerable excess over that required to sustain the exothermic reaction with the metallic material layer, in order that the substrate retains its mechanical integrity once the metallic material layer has been consumed. A polymeric substrate in the form of sheet or plate having a thickness of at least 1mm, preferably at least 2mm, will normally be required in these circumstances.

In one such application, which relates to the use of the present pyrotechnic material in a delay train, the one or more layers of metallic material are preferably overlaid by a reactive laminate comprised by a plurality of films of an oxidisable material alternately layered with a plurality of films of an oxidising material, each subsequently vapour deposited upon the metallic material layer, and the said two materials within the films being conjointly capable of reacting together exothermically upon ignition. Here, the object is generally to provide a delay train with a relatively slow burning rate, the materials of the films together being selected to have a slower lateral progression of their conjoint exothermic reaction than that of the underlying metallic and polymeric materials combination so that heat transmitted from the faster exothermic reaction underlying the laminate is used to help sustain the overlying, slower exothermic reaction within the reactive laminate. In order to provide an adequate heat source for the reactive laminate, the thickness of the one or more metallic materials layers is preferably greater then the average film thickness of the films in the laminate. The overlying laminate will generally have a lower specific heat of combustion than the underlying metal/polymer combination, and surprisingly it has been found that it is primary this laminate and not the underlying metal/polymer combination which controls the burning rate of the delay train. Preferred combinations of materials in the reactive laminate which have relatively slow burning rates are metal/inorganic oxidising agent combinations such as titanium/lead oxide, titanium/boron, and other metal/metal oxide combinations which can undergo a "thermite" type reaction. In this way far fewer films need be deposited in order to provide a self-sustaining exothermic reaction in the reactive laminate than if it were deposited on a passive, insulating substrate, with the number of the said films in the present reactive laminate being preferably from 4 to 50, most preferably from 6 to 20. Furthermore, the reactive laminate generally exhibits improved adherence to a metallic underlying layer than to an insulator such as a ceramic material or a polymer.

Preferably, each film of the reactive laminate is sequentially deposited upon the metallic material layer by vacuum deposition or sputtering, the deposition process being controlled to ensure that the thickness of each film is of substantially molecular order and is most preferably not more that 2 »m (microns) so as to maximise molecular intermingling of the film materials throughout the thickness of the laminate. The laminate may further include one or more films of an inert moderating material such as silicon, which is selectively interlayered with the said two pluralities of films during the deposition process so as to moderate the lateral progression characteristics of the exothermic reaction within the laminate, thereby to achieve a desired burning rate and/or a desired sensitivity to ignition stimulation from (for example) an electrical source.

The lateral dimensions of the reactive laminate are selected to define the width and length of a reaction progression path. These may be determined by the configuration of the substrate itself. For example, the films may be deposited upon one whole surface of a metal-coated planar substrate and subsequently processed by known printed circuit techniques to produce any desired configuration of progression paths. In a further alternative method, the planar substrate may be masked prior to deposition of the metallic layer, so as to permit deposition of the layer and subsequent deposition of the laminate in the desired configuration only. Either of these latter two planar methods is particularly advantageous for the manufacture of complex multi-train systems, as the integral deposition of all the progression paths of the system thus made possible eliminates the need for undesirable interfaces between progression paths. A planar arrangement is also to be preferred when sealed confinement of the progression paths is required, an overlaid cover of an inert material, preferably of low thermal conductivity, being readily sealable to the substrate. Such confinement acts both to contain the reaction and hence the burning rate. Consequently the closeness of confinement may be varied to provide further control of the progression characteristic.

In a further application of the present pyrotechnic material in a pyrotechnic train, in this case a single or multi-train flash transfer system, two substrates of oxidising polymeric material contact one another in a face-to-face arrangement, the facing surfaces of the substrates defining one or more trackways between them which contain opposing layers of the metallic material each deposited on its respective associated substrate. The selected lateral dimensions of the one or more trackways define the width and length of a desired reaction progression path. Ignition of these layers at any desired location produces an exothermic reaction which progresses laterally along the one or more trackways confined between the substrates (which are preferably planar) but without necessarily disturbing the substrates themselves if they are of appreciable thickness and/or supported by other supporting structures. Where the system has two or more connected pathways, integral deposition of these pathways can be employed which obviates the need for undesirable interconnections.

Overall, the present pyrotechnic materials generally have the advantage of simplicity of manufacture, safe manufacture and handling, reliability, low cost, low weight, ease of ignition, flexibility (when the substrate is in the form of a film), robustness, stability, and (when used in a pyrotechnic delay train) precision of delay timing.

Embodiments of the pyrotechnic materials according to this invention and their uses will now be described by way of example only with reference to the accompanying drawings in which
Figures 1 and 2 show perspective part sectional views of pyrotechnic materials,
Figure 3 shows a perspective part-sectional view of flash transfer cord employing the material illustrated in Figure 2,
Figure 6 shows a plan view of a sealed planar pyrotechnic multi-train,
Figure 7 shows a sectional elevation taken on the line I-I of Figure 6,
Figure 8 shows a plan view of a pyrotechnic multi-train employing a face-to-face arrangement of two pyrotechnic materials, and
Figure 9 shows a sectional elevation taken on the line II-II of Figure 8.

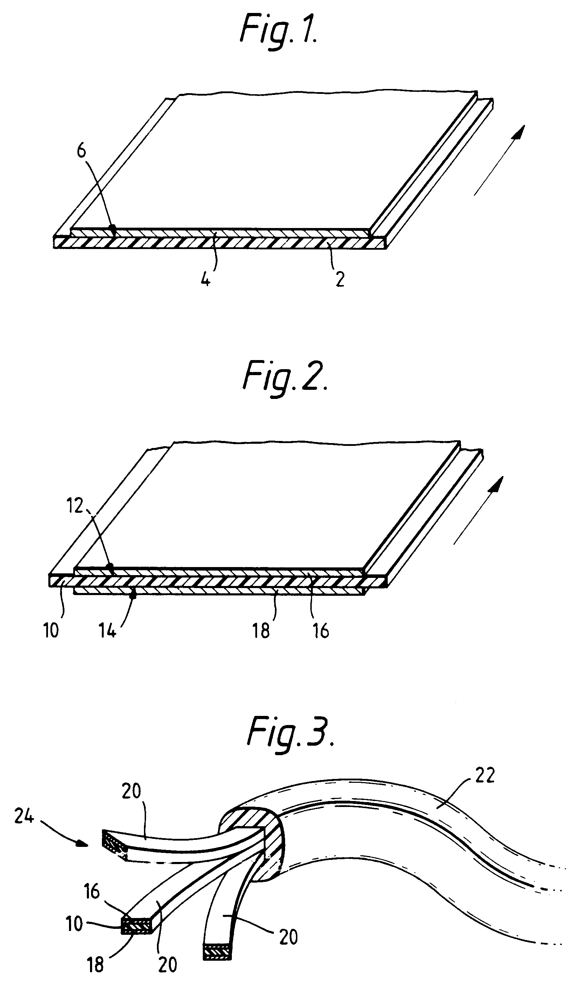

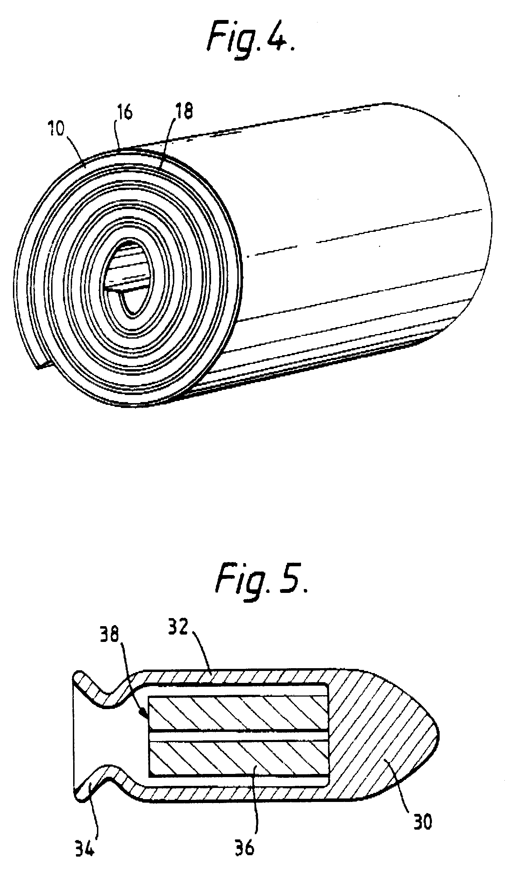

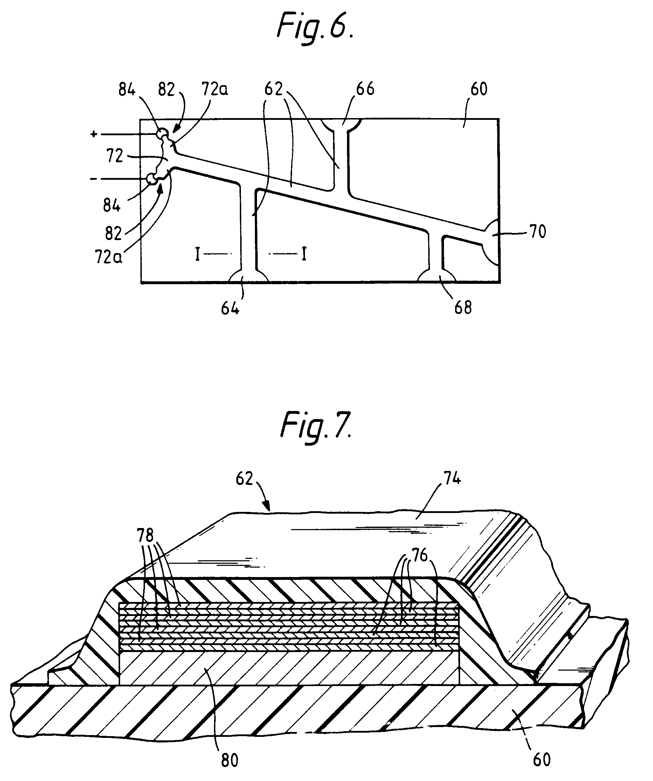

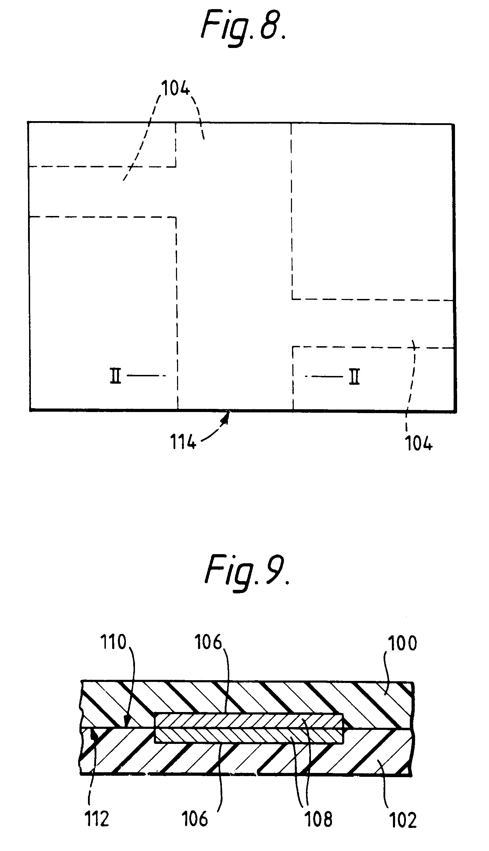

Referring first to Figure 1, a first pyrotechnic material consists of a substrate comprising an oxidising polymeric film tape 2, having a single layer 4 of an oxidisable by metallic material (for example, magnesium) deposited on one surface 6 thereof. The direction of the long axis of the tape 2 is indicated an arrow. The layer 4 is deposited using conventional vacuum deposition equipment (not shown). The deposition source material may be located in a separate vaporising boat (not shown) and vaporised by a scanned electron beam in an atmosphere of argon. Alternatively, the source may comprise a bar of material which is subjected to magnetron sputtering. Referring to Figure 2, a second pyrotechnic material consists of an oxidising polymeric film tape 10 coated on both of its surfaces 12 and 14 with layers 16 and 18 respectively of an oxidisable metal. Again, conventional vapour deposition techniques are used to deposit the layers 16 and 18.

The first and second pyrotechnic materials illustrated in Figures 1 and 2 can be edge-trimmed prior to use to remove uncoated film.

Referring to Figure 3, a flash transfer cord is shown which consists of three longitudinal strips 20 of coated tape encased within a sleeve 22 of a heat-shrunk plastics material. The strips 20 are cut from coated tape of the type illustrated in Figure 2. The sleeve 22 is heat-shrunk onto the strips 20 in order to provide adequate protection for and confinement of the strips. When ignition is applied to one open end 24 of the cord, combustion is rapidly communicated along its length in the direction shown by the arrow. By varying the relative thickness of the tape 10 and the layers 16 and 18, and in particular by varying the degree of consolidation and confinement of the strips 20, the rate and speed of combustion along the cord can be varied.

The sealed planar pyrotechnic multi-train illustrated in Figures 6 and 7 comprises a polymeric substrate plate 60 upon which is superimposed a network of reactive laminate progression paths 62 variously interconnecting and extending into edge terminals 64, 66, 68 and 70 from a bifurcated initiation terminal 72.

The network of paths 62 is overlaid by a correspondingly configured cover 74 which is peripherally sealed to the substrate plate 60 except at the terminals 64 to 72. The cover is preferably of an elastomeric material such as PTFE which will expand during combustion of the paths 62 and so prevent an excessive build-up of pressure which could otherwise produce over-rapid combustion. As an alternative to covers for each pathway, the entire surface of the plate 60 may be coated in a cover material which is preferably elastomeric, by for example dipping the substrate in or spraying the substrate with cover material in a liquid state.

Each path comprises a stack of alternatively deposited coreactive films 76 and 78 overlaid on a deposited layer 80 of metal, which layer of metal is relatively much thicker than the films 76 and 78. The films 76 and 78 are respectively of oxidisable and oxidising materials. The plate 60 and layer 80 comprise an oxidising polymer and an oxidisable metallic material respectively.

Many deposition materials are appropriate for the films, layer and plate, one example being titanium for films 76, lead oxide for films 78, PTFE for the plate 60 and magnesium for the layer 80. Each arm 72a of the bifurcated initiation terminal 72 includes a waisted portion 82. The extremities 84 of these arms beyond the waisted portions are stripped down to the layer 80 and are connected across a low voltage DC power supply (not shown).

The paths 62 are formed upon the plate 60 in a method of manufacture now to be described.

One whole face of the substrate 60 is first suitably prepared and masked with a masking plate (not shown) having therein a network of slots corresponding to the network of paths 62. The layer 80 and the films 76 and 78 are then coated in appropriate sequences onto the substrate plate 60 through the mask using conventional vacuum deposition equipment (not shown). The deposition source materials eg magnesium, titanium, and lead, are each located in separate vaporising boats and are vaporised in turn by an electron beam in an atmosphere of argon, controlled amounts of oxygen being admitted during the periods of lead vaporisation. After completion of the deposition process, the mask is removed and the cover is then superimposed and edge-sealed to the substrate 60, by means of a compatible sealant.

It will be apparent to those skilled in the art that a similar network of paths 62 can be alternatively achieved by first coating the entire surface of the plate 60, masking the required areas of the deposited laminate, ie the network of paths 62, and removing the remaining areas of deposited material by acid etching in the manner of known printed circuit board production techniques.

To ensure a reliable reaction progression characteristic the thickness of each deposited film 76 and 78 is preferably no greater than 2 »m (microns), films of greater thickness being undesirable as their heat absorption may be sufficient to extinguish the exothermic interlayer reaction between the films. The layer 80, on the other hand, is preferably thicker than 2 »m (microns) and is conveniently up to 30 »m (microns) thick, since its function is to react exothermically with the polymeric substrate plate 60 and so provide a source of heat for the films 76 and 78 necessary to initiate and sustain their combustion. The minimum number of reactive films 76 and 78 required is dependant upon the thickness of the layer 80 and the amount of heat generated by its exothermic reaction with the underlying regions of the plate 60.

It has been found that a 10 »m (micron) thick magnesium layer 80 deposited on a 3mm thick PTFE plate 60 is sufficient to sustain exothermic reaction between 4 1»m (one-micron) thick films 76 of titanium and 4 1»m (one-micron) thick films 78 of lead oxide. The thus deposited films 76 and 78 each have a columnar crystal lattice structure intermolecularly engaged with each next adjacent lattice providing a reactive laminate which once ignited sustains an inter-lattice exothermic reaction aided by the heat generated from the underlying exothermic reaction between the layer 80 of metal and the substrate plate 60. The burning rate of this laminate along the paths 62 was found to be constant and in the velocity region of 20-100 mms⁻¹.

In use, the progression path network is ignited by an electrical current which is passed across the bifurcated initiation terminal 72 between the two exposed extremities 84. Resistive heating creates local hot-spots at the two waisted portions 82 which simultaneously ignites the multi-train at these two points. The resulting exothermic reaction progresses along the paths 62 at uniform rate to provide an initiation source at each one of the remaining terminals 64 to 70 at intervals precisely determined by the lengths of the intervening paths. Surprisingly, the burning rate along the substrate 60 of the films 76 and 78, which is preferably considerably slower than that between the underlying substrate 60 and metal layer 80, tends to dictate the overall burning rate along the paths 62. In application, all or any of the terminals 64 to 70 may be used to initiate other ongoing delays or terminal events. The thickness of the plate 60 is selected to ensure that it remains intact throughout the combustion along the paths 62.

It will be apparent to those skilled in the art that other, more complex delay train networks can be produced in accordance with the invention. For example, specialised event initiators can be formed integrally with the paths at selected terminals during manufacture. In addition, alternative routes can be built into any particular multi-train so as to permit selection of delay times.

The pyrotechnic multi-train illustrated in Figures 8 and 9 comprises two plates 100, 102 of an oxidising polymeric material such as PTFE having an enclosed network of planar pyrotechnic reactive pathways 104 extending between the two. The pathways 104 are made up from a series of shallow channels 106 cut in each plate 100, 102 to a depth of at least 3 »m (microns), the channels in one plate being a mirror image of the channels in the other so that when the plates are placed together face-to-face, the pathways are defined by the opposing channels in each plate. Prior to assembly, a layer 108 of an oxidisable metal such as Mg is vapour-deposited into each of the channels 106 until each is flush with its adjacent facing surface 110, 112 of its associated plate 100, 102. When the plates are brought together, opposing layers 106 engage one another and the pathways 104 are thereby completely filled with metal. In use, ignition of the train at the end face 114 by, for example, localised resistive heating produces rapid combustion along the pathways 104 at a velocity of the order of 100 ms⁻¹.

## Claims

1. Pyrotechnic material characterised in that a substrate (2, 10, 60, 100, 102) of an oxidising polymeric material, not being a substrate film comprising an oxidising halogenated polymeric material, has vapour deposited thereon at least one layer (4, 16, 18, 80, 108) of an oxidisable metallic material in at least one location on the surface of the substrate, the at least one layer being at least 3 »m (microns) thick and the polymeric and metallic materials being conjointly capable of reacting together exothermically on ignition.

2. Pyrotechnic material according to claim 1 characterised in that the polymeric material (2, 10, 60, 100, 102) contains chemically bound within its structure oxidising atoms selected from the group consisting of halogens, oxygen, sulphur, nitrogen and phosphorus.

3. Pyrotechnic material according to claim 1 or claim 2 characterised in that the metallic material (4, 16, 18, 80, 108) comprises a metal selected from the group consisting lithium, sodium, magnesium, beryllium, calcium, strontium, barium, aluminium, titanium, zirconium, and alloys thereof.

4. Pyrotechnic material according to claim 2 and claim 3 characterised in that the polymeric material (2, 10, 60, 100, 102) comprises a fluorinated polymer and the metallic material (4, 16, 18, 80, 108) comprises magnesium or an alloy thereof.

5. Pyrotechnic material according to claim 4 characterised in that the polymeric material (2, 10, 60, 100, 102) comprises PTFE and the metallic material comprises magnesium.

6. Pyrotechnic material according to any one of the preceding claims characterised in that the one or more layers of metallic material are overlaid by a reactive laminate comprising a plurality of films of an oxidisable material (76) alternately layered with a plurality of films of oxidising material (78), each sequentially vapour deposited upon the one or more metallic material layers (80), the oxidisable and oxidising materials within the laminate being conjointly capable of reacting together exothermically upon ignition.

7. Pyrotechnic material according to claim 6 characterised in that the total number of films (76, 78) of oxidisable and oxidising materials in the reactive laminate is from 4 to 50, preferably from 6 to 20.

8. Pyrotechnic material according to claim 6 or claim 7 characterised in that the total thickness of the one or more layers of metallic material (80) is greater than the average film thickness of the films within the reactive laminate.

9. Pyrotechnic delay train characterised by the inclusion of pyrotechnic material according to any one of claims 6 to 8.

10. Pyrotechnic train comprising two pyrotechnic elements of pyrotechnic material according to any one of the preceding claims 1 to 5 in contact with one another in a face-to-face arrangement, the facing surfaces of the polymeric substrates (100, 102) of the elements defining one or more trackways (106) between said elements which contain opposing, vapour-deposited layers of the oxidisable metallic material (108).

## Patentansprüche

1. Pyrotechnisches Material,
dadurch gekennzeichnet,
daß ein Substrat (2, 10, 60, 100, 102) aus einem oxidierenden Polymermaterial, das kein Substratfilm aus einem oxidierenden halogenierten Polymermaterial ist, wenigstens eine darauf dampfabgeschiedene Schicht (4, 16, 18, 80, 108) aus einem oxidierbaren Metallmaterial an wenigstens einer Stelle auf der Oberfläche des Substrats aufweist, welche wenigstens eine Schicht wenigstens 3 »m (Mikrons) dick ist und welche Polymer- und Metallmaterialien gemeinsam geeignet sind, bei Zündung miteinander exotherm zu reagieren.

2. Pyrotechnisches Material nach Anspruch 1,
dadurch gekennzeichnet,
daß das Polymermaterial (2, 10, 60, 100, 102) innerhalb seiner Struktur chemisch gebundene oxidierende Atome enthält, die aus der aus Halogenen, Sauerstoff, Schwefel, Stickstoff und Phosphor bestehenden Gruppe gewählt sind.

3. Pyrotechnisches Material nach Anspruch 1 oder Anspruch 2,
dadurch gekennzeichnet,
daß das Metallmaterial (4, 16, 18, 80, 108) ein Metall aufweist, das aus der aus Lithium, Natrium, Magnesium, Beryllium, Calcium, Strontium, Barium, Aluminium, Titan, Zirkonium und deren Legierungen bestehenden Gruppe gewählt ist.

4. Pyrotechnisches Material nach Anspruch 2 und Anspruch 3,
dadurch gekennzeichnet,
daß das Polymermaterial (2, 10, 60, 100, 102) ein fluoriertes Polymer aufweist und das Metallmaterial (4, 16, 18, 80, 108) Magnesium oder eine Legierung davon aufweist.

5. Pyrotechnisches Material nach Anspruch 4,
dadurch gekennzeichnet,
daß das Polymermaterial (2, 10, 60, 100, 102) PTFE aufweist und das Metallmaterial Magnesium aufweist.

6. Pyrotechnisches Material nach irgendeinem der vorstehenden Ansprüche,
dadurch gekennzeichnet,
daß die eine oder mehreren Schichten aus Metallmaterial von einem reaktiven Laminat überdeckt sind, das eine Mehrzahl von Filmen aus einem oxidierbaren Material (76) aufweist, die abwechselnd mit einer Mehrzahl von Filmen aus oxidierendem Material (78), deren jeder nacheinander auf der einen oder den mehreren Metallmaterialschichten (80) dampfabgeschieden wurde, geschichtet sind, welche oxidierbaren und oxidierenden Materialien im Laminat gemeinsam geeignet sind, bei Zündung miteinander exotherm zu reagieren.

7. Pyrotechnisches Material nach Anspruch 6,
dadurch gekennzeichnet,
daß die Gesamtzahl der Filme (76, 78) aus oxidierbaren und oxidierenden Materialien im reaktiven Laminat 4 bis 50, vorzugsweise 6 bis 20 ist.

8. Pyrotechnisches Material nach Anspruch 6 oder Anspruch 7,
dadurch gekennzeichnet,
daß die Gesamtdicke der einen oder mehreren Schichten aus Metallmaterial (80) größer als die Durchschnittsfilmdicke der Filme im reaktiven Laminat ist.

9. Pyrotechnische Verzögerungsstrecke,
gekennzeichnet durch den Einschluß von pyrotechnischem Material nach irgendeinem der Ansprüche 6 bis 8.

10. Pyrotechnische Strecke, die zwei pyrotechnische Elemente aus pyrotechnischem Material nach irgendeinem der vorstehenden Ansprüche 1 bis 5 in direktem gegenseitigem Flächenkontakt aufweist, wobei die einander zugewandten Oberflächen der Polymersubstrate (100, 102) der Elemente einen oder mehrere Bahnwege (106) zwischen den Elementen definieren, die gegenüberliegende dampfabgeschiedene Schichten des oxidierbaren Metallmaterials (108) enthalten.

## Revendications

1. Matière pyrotechnique caractérisée en ce qu'un substrat (2, 10, 60, 100, 102) en une matière polymère oxydante, qui n'est pas un film de substrat comprenant une matière polymère halogénée oxydante, comporte, déposée à partir d'une phase vapeur, au moins une couche (4, 16, 18, 80, 108) d'une matière métallique oxydable située en au moins un endroit de la surface du substrat, au moins une couche ayant une épaisseur d'au moins 3 »m (micromètres) et les matières polymère et métallique étant capables conjointement de réagir ensemble de manière exothermique lors de leur allumage.

2. Matière pyrotechnique selon la revendication 1, caractérisée en ce que la matière polymère (2, 10, 60, 100, 102) contient, chimiquement fixés au sein de sa structure, des atomes oxydants choisis dans l'ensemble consistant en des halogènes, de l'oxygène, du soufre, de l'azote et du phosphore.

3. Matière pyrotechnique selon la revendication 1 ou la revendication 2, caractérisée en ce que la matière métallique (4, 16, 18, 80, 108) comprend un métal choisi dans l'ensemble consistant en le lithium, le sodium, le magnésium, le béryllium, le calcium, le strontium, le baryum, l'aluminium, le titane, le zirconium et leurs alliages.

4. Matière pyrotechnique selon la revendication 2 et la revendication 3, caractérisée en ce que la matière polymère (2, 10, 60, 100, 102) comprend un polymère fluoré et en ce que la matière métallique (4, 16, 18, 80, 108) comprend du magnésium ou un de ses alliages.

5. Matière pyrotechnique selon la revendication 4, caractérisée en ce que la matière polymère (2, 10, 60, 100, 102) comprend, ou est constituée par, du PTFE (polytétrafluoréthylène), et la matière métallique comprend, ou est constituée par, du magnésium.

6. Matière pyrotechnique selon l'une quelconque des revendications précédentes, caractérisée en ce que la couche unique ou plusieurs couches de la matière métallique est ou sont surmontée(s), par un stratifié réactif comprenant plusieurs films d'une matière oxydable (76) disposés en alternance avec plusieurs films d'une matière oxydante (78), chaque couche étant déposée à partir d'une phase vapeur sur la ou les diverses couches (80) de la matière métallique, les matières oxydable et oxydante au sein du stratifié étant conjointement capables de réagir ensemble de manière exothermique lors de leur allumage.

7. Matière pyrotechnique selon la revendication 6, caractérisée en ce que le nombre total de films (76, 78) des matières oxydable et oxydante dans le stratifié réactif est de 4 à 50, de préférence ce nombre est de 6 à 20.

8. Matière pyrotechnique selon la revendication 6 ou la revendication 7, caractérisée en ce que l'épaisseur totale de la couche unique ou des plusieurs couches de la matière métallique (80) est supérieure à l'épaisseur moyenne des films compris au sein du stratifié réactif.

9. Train de retard pyrotechnique, caractérisé par l'inclusion de la matière pyrotechnique selon l'une quelconque des revendications 6 à 8.

10. Train pyrotechnique, comprenant deux éléments pyrotechniques en une matière pyrotechnique selon l'une quelconque des revendications 1 à 5 précédentes, en contact l'une avec l'autre, dans un agencement du type face à face, les surfaces en regard des substrats polymères (100, 102) des éléments délimitant entre lesdits éléments une ou plusieurs voies (106) qui contiennent des couches opposées, déposées en phase vapeur, de la matière métallique oxydable (108).
